(19) Europäisches Patentamt
European Patent Office
Office européen des brevets

(11) **EP 1 801 961 A2**

(12) **EUROPEAN PATENT APPLICATION**

(43) Date of publication:
**27.06.2007 Bulletin 2007/26**

(51) Int Cl.:
***H02N 13/00*** $^{(2006.01)}$

(21) Application number: **06256469.5**

(22) Date of filing: **20.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **22.12.2005 JP 2005370412**

(71) Applicant: **NGK INSULATORS, LTD.**
**Nagoya-City, Aichi Pref.  467-8530 (JP)**

(72) Inventors:
• **Morioka, Ikuhisa,**
**NGK Insulators, Ltd.**
**Nagoya-City, Aichi-ken 467-8530 (JP)**
• **Tsuruta, Hideyoshi,**
**NGK Insulators, Ltd.**
**Nagoya-City, Aichi-ken 467-8530 (JP)**
• **Kawajiri, Tetsuya,**
**NGK Insulators, Ltd.**
**Nagoya-City, Aichi-ken 467-8530 (JP)**
• **Torigoe, Takeru,**
**NGK Insulators, Ltd.**
**Nagoya-City, Aichi-ken 467-8530 (JP)**

(74) Representative: **Paget, Hugh Charles Edward et al**
**Mewburn Ellis LLP**
**York House**
**23 Kingsway**
**London WC2B 6HP (GB)**

(54) **Electrostatic chuck**

(57)     An electrostatic chuck includes: a base body; an electrode formed on the base body and generating coulomb force; and a dielectric layer formed on the base body and electrode, having a plurality of projections on a first main face on the side supporting a substrate attracted by the coulomb force, and supporting the substrate on the upper surfaces of these projections. The projections are arranged at substantially uniform intervals. The surface roughness (Ra) of the projection upper faces is 0.5 $\mu$m or smaller. The height of the projections is 5 to 20 $\mu$m. The relation $A^{1/2} \times B^2 > 200$ is satisfied where A (number/100 cm$^2$) is the number of the projections per unit area of 100 cm$^2$ in the first main face, and B ($\mu$m) is the height of the projections.

EP 1 801 961 A2

**Description**

**CROSS-REFERENCE TO RELATED APPLICATION**

This application is based upon and claims the benefit of priority from Patent Application No. 2005-370412 filed on December 22, 2005, in the Japanese Patent Office, of which the contents are incorporated herein by reference.

**BACKGROUND OF THE INVENTION**

**1. Field of the Invention**

The present invention relates to an electrostatic chuck using coulomb force.

**2. Description of Related Art**

Conventionally, electrostatic chucks, which attract and hold a semiconductor substrate or glass substrate, are used in the steps of exposure, physical vapor deposition (PVD), chemical vapor deposition (CVD), etching, and the like of a semiconductor device manufacturing process or liquid crystal device manufacturing process. The electrostatic chucks can be classified into those attracting a substrate by using coulomb force, and those attracting a substrate by using Johnson-Rahbeck force.
In the above-mentioned steps of exposure, PVD, CVD, etching, and the like, there have hitherto been some cases where particles adhere to a substrate when an electrostatic chuck attracts the substrate. Moreover, the temperature distribution across a substrate has not been sufficiently uniform.
In this connection, there have been electrostatic chucks in which projections are provided on the substrate-attracting surface of the electrostatic chuck so that the area of contact between the electrostatic chuck and the substrate is reduced, whereby particles adhering to the substrate are reduced (for example, see Japanese Utility Model Application Publication No. H04-88095).
Moreover, there have been electrostatic chucks in which when a substrate is attracted onto the top portions of the projections, a backside gas is introduced into a space created between the substrate and the electrostatic chuck, whereby the uniformity of temperature distribution across the substrate is enhanced (for example, see Japanese Patent Application Unexamined Publication Nos. H07-153825 and 2002-222851).
However, these electrostatic chucks are not those using Coulomb force but those using Johnson-Rahbeck force or those having another mechanical system. In the case of an electrostatic chuck using Johnson-Rahbeck force, because of its mechanism of generating attraction force, it is necessary to pass an electric current through a substrate. There has been apprehension about the possibility that a device formed on the substrate surface might be damaged due to this current.
On the other hand, in the case of an electrostatic chuck using Coulomb force, although it is not necessary to pass an electric current through a substrate, the attraction force thereof is relatively small in comparison with that of an electrostatic chuck using Johnson-Rahbeck force. Therefore, to increase the attraction force, electrostatic chucks of this type are generally based on the concept that the permittivity of a dielectric layer is increased, that the thickness of a dielectric layer is reduced, or that the area of contact with a substrate is increased.
As described above, for the electrostatic chucks using Coulomb force, active challenges have hitherto been addressed to increase the attraction force for chucking a substrate. However, for the electrostatic chucks using coulomb force, few efforts have been devoted to reduce particles adhering to a substrate. This is because it is thought that the area of contact with a substrate needs to be enlarged to increase the attraction force, and enlarging the area of contact with a substrate can be disadvantageous to the matter of particles adhering to the substrate.
That is, reducing the area of contact between an electrostatic chuck and a substrate results in the reduced attraction force of the electrostatic chuck using Coulomb force. Therefore, for the electrostatic chucks using coulomb force, few studies have hitherto been made to reduce particles adhering to a substrate by decreasing the area of contact with the substrate.
Therefore, it has been difficult for an electrostatic chuck using Coulomb force to achieve both the maintenance of the attraction force and a reduction of particles adhering to a substrate.
Accordingly, it is an object of the present invention to provide an electrostatic chuck using Coulomb force that achieves a reduction of particles adhering to a substrate, while maintaining the attraction force.

**SUMMARY OF THE INVENTION**

An electrostatic chuck according to the present invention includes: a base body; an electrode formed on the base body and generating coulomb force; and a dielectric layer formed on the base body and electrode, having a plurality of projections on a first main face on the side supporting a substrate attracted by the coulomb force, and supporting the substrate on the upper faces of these projections, wherein the projections are arranged at substantially uniform intervals; the surface roughness (Ra) of the upper faces of the projections is not greater than 0.5 $\mu$m; the height of the projections is 5 to 20 um; and a relation of the following expression is satisfied: $A^{1/2} \times B^2 > 200$, where A (number/100 cm$^2$) is the number of the projections per unit area of 100 cm$^2$ on the first main face, and B ($\mu$m) is the height of the projections.

According to such an electrostatic chuck, even if it is an electrostatic chuck using Coulomb force, the fact that the surface roughness (Ra) of the projection upper faces is not greater than 0.5 $\mu$m makes it possible to reduce particles accumulating on the projection upper faces. Accordingly, particles adhering to the substrate can be reduced.

Moreover, if particles accumulate on the projection upper faces, the fact that the surface roughness (Ra) of the projection upper faces is not greater than 0. 5 $\mu$m makes it easier to remove the particles. Accordingly, particles on the projection upper faces can be reduced. In addition, a leakage of a backside gas introduced between the substrate and the electrostatic chuck to a chamber can be reduced.

On the other hand, in the case where the surface roughness (Ra) of the projection upper faces is greater than 0.5 $\mu$m, particles easily accumulate on the projection upper faces, and hence particles adhering to the substrate are increased. Moreover, the attraction force occurring between the projection upper faces and the substrate is reduced, with the result that the substrate cannot be held.

Moreover, the fact that the projection height is not smaller than 5 $\mu$m makes it possible to reduce contact of the substrate with the first main face even if the substrate is bent due to the attraction force.

Further, the fact that the projection height is not greater than 20 $\mu$m makes it possible to maintain the attraction force because the attraction force occurs also in a space, created by virtue of the projections, between the substrate and the first main face.

On the other hand, in the case of a projection height smaller than 5 $\mu$m, the substrate is brought in contact with the first main face when it is bent. Accordingly, particles adhering to the substrate are significantly increased. In addition, in the case of a projection height greater than 20 $\mu$m, the attraction force is remarkably reduced, making it impossible to hold the substrate.

Moreover, with the intervals between the projections, the surface roughness of the projection upper faces and the projection height set in the respective suitable ranges as described above, when the relation $A^{1/2} \times B^2 > 200$ is satisfied where A (number/100 cm$^2$) is the number of the projections per unit area of 100 cm$^2$ on the first main face and B ($\mu$m) is the height of the projections, then the area of contact between the substrate and the electrostatic chuck is reduced while the attraction force is maintained. On the other hand, when the relation $A^{1/2} \times B^2 > 200$ is not satisfied, the substrate comes in contact with the first main face, resulting in significantly increased particles adhering to the substrate.

The electrostatic chuck according to the present invention meeting these requirements can realize an electrostatic chuck using Coulomb force that achieves a reduction of particles adhering to the substrate while maintaining the attraction force.

Moreover, unlike an electrostatic chuck using Johnson-Rahbeck force, the electrostatic chuck according to the present invention, which uses Coulomb force, does not require an electric current to be passed through a substrate. Therefore, no destruction occurs in a device on the surface of the substrate.

More preferably, the projection height is not greater than 10 $\mu$m. According to this, the fact that the distance between the first main face and the substrate is reduced makes it possible to further increase the Coulomb force generated in the space between the first main face and the substrate. Accordingly, the attraction force strong enough to chuck the substrate can occur.

Preferably, the dielectric layer contains at least one of alumina, aluminum nitride, yttria, boron nitride, silicon nitride, and silicon carbide. According to this, the fact that the dielectric layer contains alumina further enhances corrosion resistance and heat resistance. Moreover, the fact that the dielectric layer contains aluminum nitride further enhances corrosion resistance, thermal uniformity across the substrate, and heat resistance. Further, the fact that the dielectric layer contains yttria further enhances corrosion resistance. Furthermore, the fact that the dielectric layer contains boron nitride further greatly enhances insulation performance and heat resistance. Still furthermore, the fact that the dielectric layer contains silicon nitride or silicon carbide further enhances heat resistance and strength.

Preferably, the volume resistivity of the dielectric layer at room temperature is not smaller than $1 \times 10^{15}$ $\Omega$·cm. According to this, practically no current flows in the dielectric layer, and no charges move. That is, the attraction force of the electrostatic chuck occurs only due to the coulomb force generated by the polarization of the dielectric layer.

Therefore, the electric chuck can immediately attract the substrate when voltage is applied, and can immediately release the substrate when voltage is turned off. For increased throughput, it is better to release the substrate as quick as possible.

It is preferable to introduce a backside gas into the space between the substrate and the first main face. According to this, the heat transfer by means of the gas can make the heat transfer across the surface of the substrate more uniform.

Preferably, the thickness of the dielectric layer is 0.05 to 0.5 mm. According to this, the dielectric strength voltage can be further increased while the strong attraction force is maintained.

Preferably, the diameter of the projection upper faces is not greater than 2.0 mm. According to this, the workability of the projection upper faces can be further enhanced. Moreover, in connection with the number of the projections per unit area described above, the intervals between the adjacent projections can be more appropriate.

Specifically, because the projections are arranged at appropriate intervals, the projections can support the substrate in a state where a deformation such as a bent is reduced. Accordingly, contact between the substrate and the first main face can be reduced. Hence, particles can be further reduced.

To reduce the number of particles, it is desirable that the area of contact between the projection upper faces and the substrate be as small as possible. However, the findings of the present inventors showed that, in the case of an electrostatic chuck using coulomb force, a substrate was not attracted to the electrostatic chuck and fell off when the contact area was simply made smaller, as in the case of an electrostatic chuck using Johnson-Rahbeck force, to reduce particles adhering to the substrate. On the other hand, in the electrostatic chuck according to the present invention, the projections are arranged at substantially uniform intervals; the surface roughness (Ra) of the projection upper faces, which support the substrate, is not greater than 0.5 $\mu$m; the projection height is 5 to 20 $\mu$m; the relation $A^{1/2} \times B^2 > 200$ is satisfied where A (number/100 cm$^2$) is the number of the projections per unit area of 100 cm$^2$ on the first main face and B ($\mu$m) is the height of the projections. More preferably, the ratio of the total area of the projection upper faces to the area of the first main face (hereinafter, referred to as contact area ratio) is not greater than 15%, still more preferably, not greater than 5%. Thereby, it is possible to significantly reduce the number of particles in comparison with a conventional electrostatic chuck, the entire surface of which comes in contact.

As described above, according to the present invention, an electrostatic chuck using coulomb force that achieves a reduction of particles adhering to a substrate while maintaining the attraction force, can be obtained.

## BRIEF DESCRIPTION OF THE DRAWINGS

The above and further objects, features and advantages of the invention will more fully appear in the detailed description of embodiments of the invention, when the same is read in conjunction with the drawings, in which:

Fig. 1 is a section view of an electrostatic chuck according to an embodiment of the present invention;

Fig. 2 is a partially enlarged section view of the electrostatic chuck according to the embodiment of the present invention; and

Fig. 3 is a plane view of the electrostatic chuck according to the embodiment of the present invention.

## DETAILED DESCRIPTION OF THE INVENTION

Next, embodiments of the present invention will be described with reference to the accompanying drawings. In the following description related to the drawings, the same or similar parts are denoted by the same or similar numerals and symbols. However, it should be noted that the drawings are schematic and are not to scale.

Therefore, concrete dimensions and the like should be determined with consideration for the following description. Moreover, each of the drawings might include a part or some parts whose dimensions and/or proportions are different from those of the equivalent part or parts in the other drawings, as a matter of course.

(Electrostatic Chuck according to an Embodiment of the Invention)

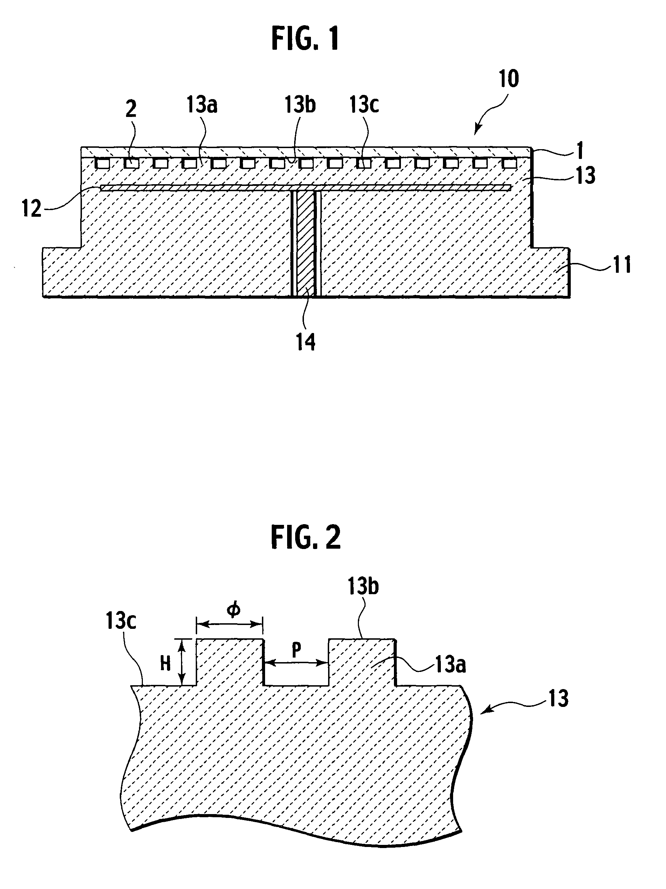

Fig. 1 is a section view of an electrostatic chuck according to an embodiment of the present invention. As shown in Fig. 1, an electrostatic chuck 10 includes: a base body 11; an electrode 12 formed on the base body 11 and generating coulomb force; a dielectric layer 13 formed on the base body 11 and electrode 12 and having a plurality of projections 13a on a first main face 13c on the side supporting a substrate attracted by the coulomb force; and a terminal 14 inserted in a hole formed from one surface of the base body 11 toward the electrode 12 and connected to the electrode 12.

The electrostatic chuck 10 illustrated has such a structure that the base body 11 and the dielectric layer 13 are integrally formed, and the electrode 12 is thereby interposed between the base body 11 and the dielectric layer 13. The electrostatic chuck 10 is an electrostatic chuck using Coulomb force, and the dielectric layer 13 functions as a dielectric layer.

The electrostatic chuck 10 has the projections 13a on the first main face 13c of the dielectric layer 13, on the side supporting a substrate 1, and chucks the substrate 1 onto projection upper faces 13b of the projections 13a. The volume resistivity of the dielectric layer 13 of the electrostatic chuck 10 at room temperature is preferably $1 \times 10^{15}$ $\Omega \cdot$cm or more, as will be described later.

The base body 11 supports the electrode 12 and dielectric layer 13. The base body 11 can be formed of a single ceramic material, a composite ceramic material, or the like. Preferably, the base body 11 is formed of a ceramic mainly composed of the same material as the main component of the dielectric layer 13. According to this, the base body 11 can enhance its airtight joint performance with the dielectric layer 13.

When the main component of the base body 11 is the same as that of the dielectric layer 13, it is further preferable that the base body 11, electrode 12 and dielectric layer 13 be formed in an integral sintered body as shown in FIG. 1. According to this, the airtightness and bonding performance between the base body 11, electrode 12 and dielectric layer 13 can be enhanced. Preferably, the integral sintered body is formed through sintering by hot pressing.

The electrode 12 generates Coulomb force between the projection upper faces 13b and the substrate 1 and between the first main face 13c and the substrate 1. The electrode 12 is interposed between the base body 11 and the dielectric layer 13. In the electrostatic chuck 10 of the present embodiment, the electrode 12 is buried between the base body 11 and the dielectric layer 13. For the electrode 12, a high melting point material comprised of any of tungsten (W), niobium (Nb), molybdenum (Mo), tantalum (Ta), hafnium (Hf), platinum (Pt), tungsten carbide (WC), an alloy thereof, a compound thereof, and the like, can be used.

Additionally, not limited to the example of being interposed between the base body 11 and the dielectric layer 13, the electrode 12 may be buried in the dielectric layer 13.

The planar shape of the electrode 12 is not particularly limited, and any of mesh, bulk, sheet, and comb profiles can be employed. Moreover, the electrode 12 is not limited to the single-electrode design shown in FIG. 1 but may be divided to be double electrodes, triple electrodes, or more.

For the electrode 12, any one of a printed material printed with printing paste, a bulk, a thin film formed by CVD (Chemical Vapor Deposition) or PVD (Physical Vapor Deposition), and the like may be used.

The terminal 14, which supplies power to the electrode 12, is inserted into the hole formed from one surface of the base body 11 toward the electrode 12 and is connected to the electrode 12 by brazing or the like.

The dielectric layer 13 is formed on the base body 11 with the electrode 12 interposed therebetween. The dielectric layer 13 has the projections 13a that support the substrate 1. According to this, the area of contact between the electrostatic chuck 10 and the substrate 1, which causes particles to occur, can be reduced to the sum of the areas of the projection upper faces 13b.

Preferably, the dielectric layer 13 contains at least one of alumina, aluminum nitride, yttria, boron nitride, silicon nitride, and silicon carbide. According to this, the following can be achieved. Specifically, the dielectric layer 13 containing alumina can enhance corrosion resistance and heat resistance. It is further preferable that the alumina is a high-purity alumina with a purity of 99.5% or greater. Moreover, the dielectric layer 13 containing aluminum nitride can enhance corrosion resistance, thermal uniformity across the substrate, and heat resistance. Further, the dielectric layer 13 containing yttria can enhance corrosion resistance. Furthermore, the dielectric layer 13 containing boron nitride can enhance insulation performance and heat resistance. Still furthermore, the dielectric layer 13 containing silicon nitride or silicon carbide can enhance heat resistance and strength.

Preferably, the volume resistivity of the dielectric layer 13 at room temperature is $1 \times 10^{15}$ $\Omega \cdot$ cm or more. According to this, release responsivity can be further enhanced. According to this, practically no current flows in the dielectric layer 13, with no movement of electric charges. That is, the attraction force of the electrostatic chuck 10 occurs only due to the coulomb force generated by the polarization of the dielectric layer 13.

Accordingly, a leakage current occurring while the substrate is being attracted can be suppressed. Moreover, when voltage is applied, the electrostatic chuck 10 can immediately attract the substrate 1, and when the voltage is turned off, the electrostatic chuck 10 can immediately release the substrate 1.

In addition, the attraction force "F" of the electrostatic chuck 10 can be expressed by the following equation:

$$F = (e^2 \times e_0 \times (V/d)^2)/2$$

where e is the relative permittivity of the material of the dielectric layer 13, $e_0$ is the permittivity of vacuum, V is the voltage applied to the electrode 12, and d is the thickness of the dielectric layer 13.

As is understood from this equation, the attraction force F occurring due to Coulomb force is proportional to the square of the application voltage V and is inversely proportional to the square of the thickness d of the dielectric layer 13. In consideration for this attraction force F, the thickness d of the dielectric layer 13, which is the distance from the base body 11 to the projection upper faces 13b, is preferably 0.05 to 0.5 mm. When the thickness d of the dielectric layer 13 is 0.05 mm or greater, the dielectric strength voltage can be further increased. When the thickness d of the dielectric layer 13 is 0.5 mm or smaller, the coulomb force can be further increased, whereby the attraction force and release responsivity can be further enhanced. The more preferred thickness d of the dielectric layer 13 is 0.1 to 0.5 mm.

In general, this attraction force F does not occur where the substrate 1 is out of contact with the dielectric layer 13. That is, it has been conventionally known that when the area of contact between the electrostatic chuck 10 and the substrate 1 is reduced with the provision of the projections 13a, the attraction force is reduced in proportion to the reduction in the contact area. Specifically, in an electrostatic chuck using coulomb force such as the electrostatic chuck 10, the source of the coulomb force is the dielectric polarization occurring in the dielectric layer 13 due to the voltage applied to the electrode 12. Therefore, no dielectric polarization is expected to occur in an area where there is no contact between the dielectric layer 13 and the substrate 1, that is, a space 2 created between the first main face 13c of the dielectric layer 13 and the substrate 1. Hence, it is a foregone conclusion that no attraction force occurs there. However, according to the present invention, this technical hurdle has been overcome by controlling the height of the projections 13a, the surface roughness of the projection upper faces 13b, and the intervals between the projections 13a within the undermentioned respective ranges, with the result that the attraction force has become able to occur also in the spaces 2.

Preferably, a backside gas is introduced into the spaces 2 between the substrate 1 and the first main face 13c created by virtue of the projections 13a. According to this, the heat transfer across the surface of the substrate 1 can be more uniform due to the heat transfer by means of the gas. For the backside gas, it is preferable to introduce, for example, helium, argon, nitrogen, a mixed gas of helium and argon, or the like, from a gas passage connected to the first main face 13c, with a pressure of 5 to 50 torrs.

The projections 13a formed on the first main face 13c will be further described with reference to Fig. 2. Fig. 2 is an enlarged view of the first main face 13c and its vicinities on the substrate-supporting side of the dielectric layer 13. Here, the first main face 13c is a virtual plane serving as the basis from which the plurality of projections 13a protrude. Excepting the portions from which the projections 13a protrude, the remainder of the first main face 13c is exposed as a surface, facing the substrate 1. Additionally, the area of the first main face 13c is calculated based upon the radius of the first main face 13c.

Referring to Fig. 2, on the first main face 13c, intervals P between the adjacent projections 13a are substantially uniform. Preferably, each interval P is 1 to 50 mm. According to this, the projections 13a can support the substrate 1 in a state where a deformation such as a bend is reduced, whereby contact between the substrate 1 and the first main face 13c can be further reduced. Thereby, particles adhering to the substrate can be further reduced. The more preferred interval P is 3 to 30 mm.

Moreover, the surface roughness (Ra (JIS B0601)) of the projection upper faces 13b of the projections 13a supporting the substrate 1 is 0.5 $\mu$m or smaller. According to this, particles accumulating on the projection upper faces 13b can be reduced. Even if particles accumulate on the projection upper faces 13b, the particles can be easily removed, whereby particles on the projection upper faces 13b can be reduced. Thereby, particles adhering to the substrate 1 can be reduced. The more preferred surface roughness (Ra) of the projection upper faces 13b is 0.2 $\mu$m or smaller.

Further, the height of the projections 13a (hereinafter referred to as projection height H), which is the distance from the projection upper faces 13b to the first main face 13c, is 5 to 20 $\mu$m. When the projection height H is 5 $\mu$m or greater, the electrostatic chuck 10 supports the substrate 1 only on the projection upper faces 13b. Accordingly, particles adhering to the substrate 1 can be reduced. In addition, when the projection height H is 20 $\mu$m or smaller, the attraction force and release responsivity can be maintained by coulomb force.

More preferably, the projection height H is 10 $\mu$m or smaller. According to this, due to the fact that the distance between the first main face 13c and the substrate 1 is reduced, the coulomb force generated between the first main face 13c and the substrate 1 is increased, and hence the attraction force strong enough to chuck the substrate 1 can occur.

Furthermore, the relation $A^{1/2} \times B^2 > 200$ is satisfied, where A (number/100 cm$^2$) is the number of the projections 13a per unit area of the first main face 13c, and B ($\mu$m) is the projection height H.

Specifically, a 10 cm square is measured off at an arbitrary position on the first main face 13c, and the number of the projections 13a within this square is determined, whereby A, the number of the projections 13a per unit area of 100 cm$^2$, is calculated. Next, based on B, which is the projection height H, the value of $A^{1/2} \times B^2$ is calculated.

The present inventors has found that the probability that the substrate 1 is in contact with the first main face 13c is inversely proportional to the number of the projections 13a per unit area, that is, inversely proportional to the square root of A, and is almost inversely proportional to the square of the projection height H. From this finding, the above-mentioned expression has been contrived. That is, when the number of the projections 13a and projection height H meet the above-mentioned expression, the attracted face of the substrate 1 is out of contact with the first main face 13c of the electrostatic chuck 10 even if the attracted substrate 1 is microscopically bent between the projections 13a due to the attraction force.

Preferably, the diameter 0 of the projection upper faces 13b is 2.0 mm or smaller. According to this, the workability of the projection upper faces 13b is further enhanced, and the uniformity of the profile of the projection upper faces 13b, such as the surface roughness, can be further increased. Thereby, particles adhering to the substrate 1 can be further reduced. Moreover, the heat transfer across the surface of the substrate 1 can be more uniform. The more preferred diameter $\varnothing$ of the projection upper faces 13b is 0.5 to 2 mm.

As described above, the electrostatic chuck 10 includes the base body 11, the electrode 12 formed on the base body 11 and generating coulomb force, and the dielectric layer 13 having the plurality of projections 13a on the first main face 13c on the side supporting the substrate 1.

Moreover, according to the electrostatic chuck 10, the intervals P between the projections 13a are substantially uniform; the surface roughness (Ra) of the projection upper faces 13b is 0.5 $\mu$m or smaller; the projection height H is 5 to 20 $\mu$m; the relation $A^{1/2} \times B^2 > 200$ is satisfied, where A (number/100 cm$^2$) is the number of the projections 13a per unit area of 100 cm$^2$ on the first main face 13c and B ($\mu$m) is the projection height H. Thereby, while the attraction force is maintained, the area of contact between the substrate 1 and the electrostatic chuck 10 can be reduced, and particles adhering to the substrate 1 can be reduced.

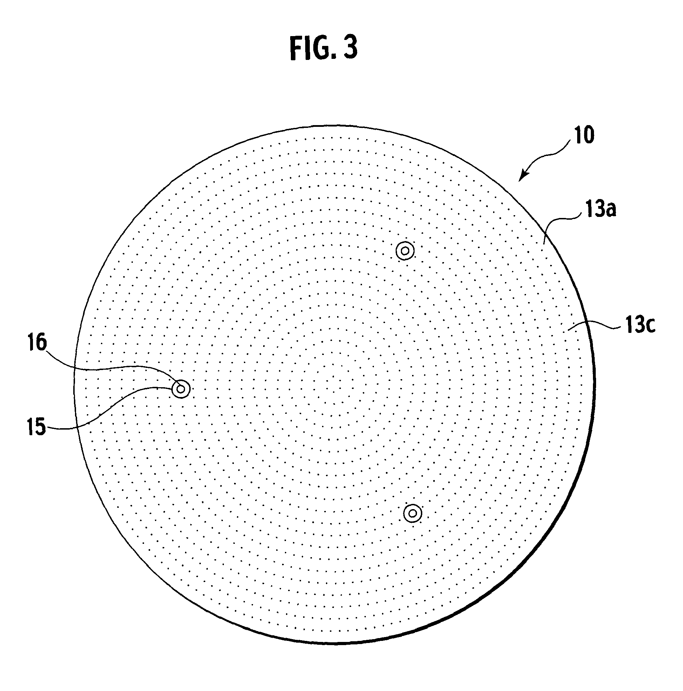

The arrangement of the projections 13a on the first main face 13c will be further described with reference to Fig. 3. Fig. 3 is a plane view of the first main face 13c of the dielectric layer 13, on the side supporting the substrate 1.

Referring to Fig. 3, on the first main face 13c, the intervals between the adjacent projections 13a are substantially uniform.

The electrostatic chuck 10 may be provided with a gas introduction hole (not shown) penetrating the base body 11 and the dielectric layer 13.

Moreover, the electrostatic chuck 10 shown in Fig. 3 has at least one substrate raising/lowering pin hole 15 penetrating the dielectric layer 13, and at least one substrate raising/lowering pin 16 is inserted into this substrate raising/lowering pin hole 15 in an ascendable and descendable manner.

Furthermore, with a resistance heating element buried in the base body 11, the electrostatic chuck 10 can make an electrostatic chuck 10 that can heat the substrate 1. For the resistance heating element, any of niobium, molybdenum, tungsten, and the like can be used. For the resistance heating element, any of a line shape, coil shape, band shape, mesh shape, film shape, and the like can be employed. The resistance heating element generates heat when supplied with power.

(Electrostatic Chuck Manufacturing Method according to Embodiment of the Invention)

An electrostatic chuck 10 as described above can be manufactured through the steps of forming the base body 11, forming on the base body 11 the electrode 12 that generates coulomb force, forming the dielectric layer 13, and forming on the dielectric layer 13 the plurality of projections 13a that support the substrate 1.

By way of example, a description will be given of the case where the base body 11 of ceramic is formed, and then the dielectric layer 13 is formed on the base body 11 with the electrode 12 interposed therebetween.

First, the step of forming the base body 11 will be described.

A binder, and any of an organic solvent, a dispersing agent and the like if necessary, are added to a ceramic material powder for the base body 11, thereby making a slurry.

The obtained slurry is granulated by spray granulation or the like, thereby obtaining granules. A compact body is made from the obtained granules by a forming method such as molding, cold isostatic pressing (CIP) or slip casting.

The obtained compact body is sintered under the conditions (sintering atmosphere, sintering method, sintering temperature, sintering time, etc.) according to the ceramic material powder. The base body 11 is formed from the sintered body by, for example, grinding.

Next, the step of forming on the base body 11 the electrode 12 generating Coulomb force will be described. The electrode 12 can be formed by printing a printing paste onto a surface of the base body 11, in a semicircular or comb-teeth-like shape, or in mesh, by screen printing or the like. When the electrode 12 is formed by printing, it is preferable to use a printing paste prepared by mixing: a high melting point material powder such as tungsten, niobium, molybdenum, or tungsten carbide; a ceramic powder of the same kind as that of the base body 11; and, as a binder, any of cellulose, acrylic, polyvinyl butyral, and the like. According to this, the thermal expansion coefficient of the electrode 12 can be made close to that of the base body 11, and the airtight joint performance between the base body 11 and the electrode 12 can be enhanced.

Additionally, the electrode 12 also can be formed by placing a mesh or bulk electrode on the surface of the base body 11. Moreover, the electrode 12 also may be formed by forming a thin film of electrode on the surface of the base body 11 by CVD or PVD.

Next, the step of forming the dielectric layer 13 will be described. It is preferable that the dielectric layer 13 contains, as the principal material, any one of alumina, aluminum nitride, yttria, boron nitride, silicon nitride, and silicon carbide. A slurry is made by mixing a ceramic raw material powder with a binder and, if necessary, any of water, a dispersing agent and the like. The ceramic raw material powder may include a ceramic powder of the principal material, a sintering aid, and a binder. For example, an alumina powder is included as the principal material, and any powder of magnesia, yttria, a titanium oxide, and the like is added as a sintering aid. However, it is preferable that the total quantity of the components other than the principal material be 0.5% by weight or smaller. In addition, it is preferable to provide such a control that the volume resistivity of the dielectric layer 13 at room temperature after sintering becomes $1 \times 10^{15}$ $\Omega \cdot$cm or greater.

The obtained slurry is subjected to granulation such as spray granulation, thereby obtaining granules. The base body 11 with the electrode 12 formed thereon is set in a mold or the like, and the obtained granules are fed onto the base body 11 and electrode 12 up to such a level that its thickness after sintering becomes 0.05 to 0.5 mm, whereby a compact body to be the dielectric layer 13 is formed on the base body 11. Alternatively, the compact body to be the dielectric layer 13 can be formed on the base body 11 also in such a manner that a compact body to be the dielectric layer 13 is formed from the granules by mold pressing, CIP, slip casting or the like, and the obtained compact body to be the dielectric layer 13 is placed on the base body 11 and pressed.

Thereafter, the base body 11, electrode 12, and compact body to be the dielectric layer 13 are integrally sintered by hot pressing under the sintering conditions (sintering atmosphere, sintering method, sintering temperature, sintering time, etc.) according to the ceramic raw material powder for the compact body, thereby obtaining an integral sintered body. Thus, the dielectric layer 13 can be formed.

Note that the steps may be carried out in any order. For example, the following order is possible: the dielectric layer 13 is first formed; the electrode 12 is formed on the dielectric layer 13; a compact body to be the base body 11 is formed on the dielectric layer 13 and electrode 12 and then integrally sintered.

As described above, after any one of the base body 11 and the dielectric layer 13 is obtained by sintering, the electrode 12 is formed, and then they are sintered integrally. Thereby, the flatness of the electrode 12 can be enhanced. Accordingly, the uniformity of the attraction force of the electrostatic chuck 10 and the uniformity of the heat transfer to the substrate 1 can be enhanced.

Additionally, the integral sintered body may be obtained also in such a manner that a laminated body is formed from a compact body to be the base body 11, the electrode 12 and a compact body to be the dielectric layer 13, and the obtained laminated body is integrally sintered by hot pressing or the like.

Further, the electrode 12 does not need to be interposed between the base body 11 and the dielectric layer 13. For example, the electrode 12 may be buried in the dielectric layer 13.

Next, the step of forming on the dielectric layer 13 the plurality of projections 13a supporting the substrate 1 will be described. The projection 13a are formed on the substrate-supporting-side surface of the dielectric layer 13 of the integral sintered body, obtained including the base body 11, electrode 12 and dielectric layer 13. Specifically, masks having dimensions similar to those of the projection upper faces 13b and such an arrangement that the intervals between their corresponding projections 13a become substantially uniform, are attached to the surface of the dielectric layer 13 on the side supporting the substrate 1. Thereafter, this surface of the dielectric layer 13 on the side supporting the substrate 1 is blasted out by sandblasting. The parts covered with the masks remain and make the projections 13a, and the parts not covered with the masks are blasted, where the first main face 13c is formed. Thus, the dielectric layer 13 having the plurality of projections 13a can be formed on the first main face 13c on the side supporting the substrate 1.

The projection height H is controlled to become 5 to 20 $\mu$m. Moreover, the projections 13a are polished so that the surface roughness (Ra) of the projection upper faces 13b becomes 0.5 $\mu$m or smaller.

Here, the number of the projections 13a and the projection height H are controlled so that the relation $A^{1/2} \times B^2 > 200$ is satisfied, where A (number/100 cm$^2$) is the number of the projections 13a per unit area of the first main face 13c, and B ($\mu$m) is the projection height H.

Preferably, the diameter of the projection upper faces 13b is 2.0 mm or smaller.

Further, a hole in which the terminal 14 is to be inserted is formed in the base body 11 by drilling. Finally, the terminal 14 is inserted into the hole in the base body 11 and brazed to the electrode 12. Thus, the electrostatic chuck 10 is obtained.

As described above, the electrostatic chuck manufacturing method includes the steps of: forming the base body 11; forming on the base body 11 the electrode 12 generating coulomb force; forming the dielectric layer 13; and forming the plurality of projections 13a on the first main face 13c of the dielectric layer 13 on the side supporting the substrate 1, whereby the electrostatic chuck 10 using coulomb force that achieves a reduced number of particles adhering to the substrate 1 while maintaining the attraction force, can be obtained. By controlling the mean particle diameter of the raw material powder, composition, and sintering conditions such as sintering temperature and time within the scope of manufacturing conditions as described above, the composition, open porosity, bulk density, mean particle diameter and the like of the sintered body can be suitably adjusted. As a result, it is possible to suitably adjust the thermal conductivity, volume resistivity and the like of the obtained electrostatic chuck 10.

(Examples)

Next, the present invention will be described in more detail by giving examples. However, the present invention is not limited to the examples described below.

(Example 1)

In Example 1, an electrostatic chuck 10 including a base body 11, an electrode 12, a dielectric layer 13, projections 13a, and a terminal 14 as shown in FIG. 1 was manufactured.

First, the base body 11 was formed. Specifically, a mixed powder was prepared as a ceramic raw material powder by mixing an alumina powder having a particle size of 1 $\mu$m and a purity of 99.5%, with a magnesium oxide having a particle size of 1 $\mu$m so that the proportion of the magnesium oxide became 0.04%. To the ceramic raw material powder, PVA (polyvinyl alcohol) serving as a binder, water and a dispersing agent were added, and the mixture was mixed for 16 hours by using a trammel, thus obtaining a slurry.

Granules were made by spray granulation. Specifically, the obtained slurry was sprayed and dried with a spray dryer, thereby making granules having a mean granule diameter of 80 $\mu$m. The obtained granules were put in a rubber mold and subjected to pressure forming in a cold isostatic pressing (hereinafter, referred to as CIP) facility at a pressure of 1 ton/cm$^2$, thus obtaining a compact body to be the base body 11.

The compact body to be the base body 11 was sintered in an air sintering furnace, thereby obtaining a sintered body. Specifically, the compact body was put in an alumina sagger. The temperature was increased up to 500°C at a temperature increase rate of 10°C/hour and kept at 500°C for five hours. Retained at 500°C, the binder contained in the compact body was removed. Thereafter, the temperature was increased from 100°C up to 1650°C at a temperature increase rate of 30°C/hour, and the compact body was sintered at 1650°C for four hours, thus obtaining the base body 11.

The base body 11 was subjected to grinding, thereby making a disk of 300 mm in diameter and 6 mm in thickness. A surface thereof was subjected to grinding to have a surface roughness (Ra) of 0.8 $\mu$m.

Next, the electrode 12 was formed. Specifically, a printing paste was prepared by mixing a tungsten (W) powder with terpineol as a binder and 40% of alumina. The electrode 12 having a diameter of 290 mm and a thickness of 10 $\mu$m was formed on the base body 11 by screen printing and then dried.

Next, the dielectric layer 13 was formed. Specifically, the base body 11 with the electrode 12 formed thereon was set in a mold. Granules granulated from a separately prepared alumina powder having a particle size of 1 $\mu$m and a purity of 99.5% were fed onto the electrode 12, and press forming was performed by pressurization at 20 MPa.

The integrally formed base body 11, electrode 12 and compact body to be the dielectric layer 13 were set in a carbon sagger and sintered in a nitrogen gas atmosphere by hot pressing. Specifically, in a nitrogen gas atmosphere at 150 kPa, the temperature was increased at a temperature increase rate of 300°C/hour up to a maximum temperature of 1600°C while applying a pressure of 10 MPa, and the integrally formed base body 11, electrode 12 and compact body to be the dielectric layer 13 were retained at this maximum temperature 1600°C for two hours and thereby integrally sintered. Thus, an integral sintered body including the base body 11, electrode 12 and dielectric layer 13 was manufactured.

Surface grinding and cylindrical grinding using a diamond grindstone were performed on the first main face 13c of the dielectric layer 13 of the integral sintered body, on the side supporting a substrate 1, thus forming a mid-form of the electrostatic chuck 10 with a diameter of 300 mm.

Next, the projections 13a were formed on the substrate-supporting-side surface. Specifically, to the substrate-supporting-side surface, masks were attached that had dimensions similar to those of the projection upper faces 13b and such an arrangement that the intervals between their corresponding projections 13a became substantially uniform. Thereafter, the substrate-supporting-side surface was selectively blasted out by sandblasting, thus forming the projections 13a having a diameter of the projection upper faces 13b (hereinafter, referred to as projection diameter) of 0.5 mm and a projection height H of 7 $\mu$m.

Here, masks were controlled so that the relation $A^{1/2} \times B^2 > 200$ would be satisfied, where A (number/100 cm$^2$) is the number of the projections 13a per unit area of 100 cm$^2$ in the first main face 13c, and B ($\mu$m) is the projection height H. More specifically, masks were controlled so that the number of the projections 13a per unit area of 100 cm$^2$ on the first main face 13c became 127.

Moreover, the projections 13a were formed such that the ratio of the total area of the projection upper faces 13b (in Table 1, referred to as contact area ratio) to the area of the first main face 13c became 1%.

Next, polishing was performed so that the surface roughness (Ra) of the projection upper faces 13b became 0.4 $\mu$m.

Furthermore, drilling was performed, and then the terminal 14 to be connected to the electrode 12 was joined. Thus, the electrostatic chuck 10 according to Example 1 was manufactured.

(Examples 2 to 11)

In each of Examples 2 to 11, an electrostatic chuck 10 including a base body 11, an electrode 12, a dielectric layer 13, projections 13a, and a terminal 14 as shown in Fig. 1 was manufactured as in Example 1.

Each of the electrostatic chucks 10 of Examples 2 to 11 was changed from that of Example 1 in contact area ratio, projection diameter, projection height H, projection surface roughness, and the number of the projections 13a per unit area of 100 cm$^2$ as shown in Table 1. The manufacturing methods of Examples 2 to 11 were similar to that of Example 1.

(Example 12)

In Example 12, an electrostatic chuck 10 including a base body 11, an electrode 12, a dielectric layer 13, projections 13a, and a terminal 14 as shown in Fig. 1 was manufactured as in Example 1.

The electrostatic chuck 10 of Example 12 was changed from that of Example 1 in volume resistivity as shown in Table 2, by admixing no magnesium oxide when the base body 11 was formed. The manufacturing method of Example 12 was similar to that of Example 1, except the admixture of no magnesium oxide.

(Comparative Examples 1 to 7)

In each of Comparative Examples 1 to 7, an electrostatic chuck including a base body 11, an electrode 12, a dielectric layer 13, projections 13a, and a terminal 14 as shown in Fig. 1 was manufactured as in Example 1.

Comparative Examples 1 and 2 are different from Examples 1 to 11 in that a condition of the present invention that $A^{1/2} \times B^2 > 200$, is not satisfied.

Specifically, in Comparative Example 1, the number of the projections 13a per unit area of 100 cm$^2$ is six, and the projection height H is 7 $\mu$m. Accordingly, $A^{1/2} \times B^2 = 124$.

In Comparative Example 2, the number of the projections 13a per unit area of 100 cm$^2$ is eight, and the projection height H is 7 $\mu$m. Accordingly, $A^{1/2} \times B^2 = 138$.

Comparative Examples 3 to 5 are different from Examples 1 to 11 in that a condition of the present invention that the projection height H should be 5 to 20 $\mu$m, is not satisfied.

Specifically, in Comparative Examples 3 to 5, the projection heights H are 4 $\mu$m, 30 $\mu$m and 22 $\mu$m, respectively.

Comparative Examples 6 and 7 are different from Examples 1 to 11 in that a condition of the present invention that the projection surface roughness should be 0.5 $\mu$m or smaller, is not satisfied.

Specifically, in Comparative Examples 6 and 7, the projection surface roughnesses are 0.6 $\mu$m and 1 $\mu$m, respectively.

(Comparative Example 8)

In Comparative Example 8, an electrostatic chuck of a Johnson-Rahbeck force type, including a base body, an electrode, a dielectric layer, and a terminal as in Example 1 was manufactured.

The electrostatic chuck of Comparative Example 8 was manufactured as in Example 1 but is different from those of Examples 1 and 12 in that an electrostatic chuck of a Johnson-Rahbeck force type was manufactured using an aluminum nitride powder.

(Test Method)

Next, the electrostatic chucks 10 of Examples 1 to 11 and Comparative Examples 1 to 7 manufactured as described above were measured for the attraction force and the number of particles.

(1) Measurement of attraction force

Using each of the electrostatic chucks 10 of Examples 1 to 11 and Comparative Examples 1 to 7, a silicon probe was attracted and fixed to the electrostatic chuck 10 in such a manner that in vacuum, the silicon probe was brought in contact with the first main face 13c having the projections 13a, and a voltage of 1500 V was applied between the electrode 12 of the electrostatic chuck 10 and the silicon probe. While the voltage is kept applied, the silicon probe was pulled in the direction in which the silicon probe would be pulled off the first main face 13c. A force required to pull the silicon probe off was divided by the area of the attracted face of the silicon probe, and the obtained value was measured as the attraction force.

(2) Measurement of particles

Using each of the electrostatic chucks 10 of Examples 1 to 11 and Comparative Examples 1 to 7, a bare silicon wafer as the substrate 1 was placed on the electrostatic chuck 10 in vacuum; a voltage of 1500 V was applied; a backside gas at a pressure of 20 torrs was introduced between the substrate 1 and the first main face 13c; the substrate 1 was left attracted for one minute. Thereafter, the voltage was reduced to 0 V, whereby the substrate 1 was released. The number of particles on the rear face of the substrate 1 was measured with a particle counter (SP-1 made by KLA).

The results of the measurement of these electrostatic chucks 10 are shown in Table 1.

(Table 1)

| | Projection height B ($\mu$m) | Projection surface roughness Ra ($\mu$m) | Number of projections A (number/100 cm$^2$) | $A^{1/2} \times B^2$ | Contact area ratio (%) | Projection diameter (mm) | Attraction force (torr) | Number of particles |
|---|---|---|---|---|---|---|---|---|
| Example 1 | 7 | 0.4 | 127 | 553 | 1 | 0.5 | 44 | 1250 |
| Example 2 | 7 | 0.4 | 25 | 247 | 0.2 | 0.5 | 43 | 920 |
| Example 3 | 7 | 0.4 | 637 | 1237 | 5 | 0.5 | 45 | 1580 |
| Example 4 | 7 | 0.4 | 1247 | 1749 | 10 | 0.5 | 46 | 3800 |
| Example 5 | 5 | 0.4 | 127 | 282 | 1 | 0.5 | 51 | 1330 |
| Example 6 | 10 | 0.4 | 127 | 1129 | 1 | 0.5 | 36 | 1080 |
| Example 7 | 20 | 0.4 | 127 | 4515 | 1 | 0.5 | 22 | 960 |
| Example 8 | 7 | 0.4 | 32 | 277 | 1 | 1 | 46 | 1190 |
| Example 9 | 7 | 0.5 | 127 | 553 | 1 | 0.5 | 29 | 1200 |
| Example 10 | 7 | 0.4 | 24 | 239 | 3 | 2 | 50 | 1230 |
| Example 11 | 7 | 0.4 | 1911 | 2142 | 15 | 0.5 | 48 | 7120 |
| Comparative Example 1 | 7 | 0.4 | 6 | 124 | 0.05 | 0.5 | 43 | 33310 |
| Comparative Example 2 | 7 | 0.4 | 8 | 138 | 1 | 2 | 50 | 22400 |
| Comparative Example 3 | 4 | 0.4 | 127 | 181 | 1 | 0.5 | 55 | 22400 |
| Comparative Example 4 | 30 | 0.4 | 127 | 10158 | 1 | 0.5 | 15 | Not chucked and unmeasurable |
| Comparative Example 5 | 22 | 0.4 | 127 | 5463 | 1 | 0.5 | 16 | Not chucked and unmeasurable |
| Comparative Example 6 | 7 | 0.6 | 127 | 553 | 1 | 0.5 | 15 | Not chucked and unmeasurable |
| Comparative Example 7 | 7 | 1 | 127 | 553 | 1 | 0.5 | 14 | Not chucked and unmeasurable |

In Comparative Example 1, the number of the projections 13a per unit area of 100 cm$^2$ was six, the projection height H was 7 $\mu$m, and A$^{1/2}$ × B$^2$ = 124. Since the number of the projections was smaller and the projection height H was lower, the substrate 1 came in contact with the first main face 13c. Therefore, about 33310 particles were generated.

Similarly, in Comparative Example 2, A$^{1/2}$ × B$^2$ = 138. Since the number of the projections was smaller and the projection height H was lower, the substrate 1 came in contact with the first main face 13c. Therefore, about 22400 particles were generated.

In Comparative Example 3, the projection height H was 4 $\mu$m, and A$^{1/2}$ × B$^2$ = 181. That is, since the number of the projections was smaller and the projection height H was lower, the substrate 1 came in contact with the first main face 13c. Therefore, about 22450 particles were generated.

In Comparative Examples 4 and 5, the projection heights H were 30 $\mu$m and 22 $\mu$m, respectively. In each case, since the projection height H was too high, the attraction force between the substrate 1 and the first main face 13c was reduced, with the result that the substrate 1 could not be chucked.

In Comparative Examples 6 and 7, the projection surface roughnesses were 0.6 $\mu$m and 1 $\mu$m, respectively. In each case, since the projection surface roughness was too rough, the attraction force between the substrate 1 and the first main face 13c was reduced, with the result that the substrate 1 could not be chucked.

On the other hand, in Examples 1 to 11 according to the present invention, in each case, while the attraction force was maintained, the number of particles adhering to the substrate 1 was able to be reduced into the range of 920 to 7120, which is an order of magnitude smaller than those of Comparative Examples.

In Example 2 in particular, the attraction force was 43 torrs, and the number of particles was 920. The number of particles was able to be greatly reduced while the attraction force was maintained.

Next, the electrostatic chucks 10 using coulomb force of Examples 1 and 12 and the Johnson-Rahbeck force type electrostatic chuck of Comparative Example 8 were individually measured for the volume resistivity, leakage current and substrate releasing time.

(3) Measurement of volume resistivity

Using each of the electrostatic chucks 10 using Coulomb force of Examples 1 and 12 and the Johnson-Rahbeck force type electrostatic chuck of Comparative Example 8, the volume resistivity was measured by a method conforming to JIS C2141. Specifically, a voltage of 2 kV/mm was applied to the electrode of the electrostatic chuck at room temperature, and the volume resistivity was calculated.

(4) Measurement of leakage current

As in (2) Measurement of particles, the substrate 1 was placed on the electrostatic chuck; a voltage of 1500 V was applied; a backside gas at a pressure of 20 torrs was introduced between the substrate 1 and the first main face 13c; the substrate 1 was left attracted for one minute. Then, a leakage current during the attraction of the substrate was measured.

(5) Measurement of substrate releasing time

As in (2) Measurement of particles, the substrate 1 was placed on the electrostatic chuck; a voltage of 1500 V was applied; a backside gas at a pressure of 20 torrs was introduced between the substrate 1 and the first main face 13c; the substrate 1 was left attracted for one minute. Then, after the voltage was reduced to 0 V, substrate releasing time, which is a period of time required to release the substrate 1, was measured.

The results of the measurement of these electrostatic chucks are shown in Table 2.

(Table 2)

| | Volume resistivity ($\Omega$·cm) | Contact area ratio (%) | Projection diameter (mm) | Projection height ($\mu$m) | Projection surface roughness Ra ($\mu$m) | Leakage current ($\mu$A) | Substrat releasing time (sec) |
|---|---|---|---|---|---|---|---|
| Example 1 | $2 \times 10^{15}$ | 1 | 0.5 | 7 | 0.4 | < 0.01 | 0.5 |
| Example 12 | $3 \times 10^{17}$ | 1 | 0.5 | 7 | 0.4 | < 0.01 | 0.5 |
| Comparative Example | $5 \times 10^{12}$ | 1 | 0.5 | 7 | 0.4 | 0.1 | > 60 |

In Example 1, the volume resistivity was $2 \times 10^{15}$ $\Omega\cdot$cm. The leakage current was smaller than 0.01 $\mu$A and was extremely minute. The substrate releasing time was 0.5 minutes, which was also extremely short.

Moreover, in Example 12, the volume resistivity was $3 \times 10^{17}$ $\Omega\cdot$cm. The leakage current, as in Example 1, was smaller than 0.01 $\mu$A and was extremely minute. The substrate releasing time was 0.2 minutes, which was also extremely short.

On the other hand, in Comparative Example 8, which is the Johnson-Rahbeck force type electrostatic chuck, the volume resistivity was $5 \times 10^{12}$ $\Omega\cdot$cm, which was lower than those of Examples 1 and 12. The leakage current was 0.1 $\mu$A, and the substrate releasing time was longer than 60 minutes.

From these results, it is confirmed that the electrostatic chucks 10 according to the present invention are electrostatic chucks using coulomb force achieving small leakage current, very short substrate releasing time and good responsivity to ON/OFF of the voltage application, in comparison with an electrostatic chuck using Johnson-Rahbeck force.

While preferred embodiments of the present invention have been described using specific terms, such description is for illustrative purposes, and it is to be understood that changes and variations may be made without departing from the spirit or scope of the claims.

**Claims**

1. An electrostatic chuck comprising:

   a base body;
   an electrode formed on the base body and generating coulomb force; and
   a dielectric layer formed on the base body and the electrode, having a plurality of projections on a first main face on a side supporting a substrate attracted by the coulomb force, and supporting the substrate on upper faces of these projections,

   wherein the projections are arranged at substantially uniform intervals,
   surface roughness (Ra) of the upper faces of the projections is not greater than 0.5 $\mu$m,
   height of the projections is 5 to 20 $\mu$m, and
   a relation of a following expression is satisfied: $A^{1/2} \times B^2 > 200$, where A (number/100 cm$^2$) is the number of the projections per unit area of 100 cm$^2$ on the first main face, and B ($\mu$m) is the height of the projections.

2. The electrostatic chuck according to claim 1, wherein the height of the projections is not greater than 10 $\mu$m.

3. The electrostatic chuck according to any one of claims 1 and 2, wherein diameter of the upper faces of the projections is not greater than 2.0 mm.

4. The electrostatic chuck according to claim 1, wherein the dielectric layer comprises at least one of alumina, aluminum nitride, yttria, boron nitride, silicon nitride, and silicon carbide.

5. The electrostatic chuck according to claim 1, wherein volume resistivity of the dielectric layer at room temperature is not smaller than $1 \times 10^{15}$ $\Omega\cdot$cm.

6. The electrostatic chuck according to claim 1, wherein thickness of the dielectric layer is 0.05 to 0.5 mm.

7. The electrostatic chuck according to claim 1, wherein a backside gas is introduced into a space between the substrate and the first main face.

## FIG. 1

## FIG. 2

# FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005370412 A
- JP H0488095 A
- JP H07153825 A
- JP 2002222851 A